# EUROPEAN PATENT APPLICATION

(11) **EP 3 863 068 A1**
(43) Date of publication of application: **11.08.2021**
(21) Application number: 20156448.1
(22) Date of filing: 10.02.2020
(51) Int. Cl.: H01L 31/05, H01L 31/0445, H01L 31/0392, H01L 31/0224

(54) **FLEXIBLE SEMI-FINISHED PHOTOVOLTAIC MODULE**

(71) Applicant: Nederlandse Organisatie voor toegepast- natuurwetenschappelijk Onderzoek TNO, 2595 DA 's-Gravenhage (NL)
(72) Inventor: VAN DEN NIEUWENHOF, Monique Allegonda Catharina J., 2595 DA's- Gravenhage (NL); ROOSEN-MELSEN, Dorrit Aldegonda, 2595 DA's- Gravenhage (NL); VAN DEN BRUELE, Fiona Joyce, 2595 DA's- Gravenhage (NL); BALDER, Joan Elisabeth, 2595 DA's- Gravenhage (NL)
(74) Representative: V.O.

(57) **Abstract**

The present disclosure relates to a 3D formable photovoltaic solar panel, in particular to a semi-finished free-formable photovoltaic module for a 3D formed solar panel, and to a method for manufacturing thereof. The semi-finished free-formable photovoltaic module comprising: a plurality of laterally spaced back contactable flexible photovoltaic elements; a plurality of flexible electrically conductive wiring elements forming an electrically conductive interconnection between flexible photovoltaic elements , each wiring element having an overlap with the respective back terminals of adjacent flexible photovoltaic elements; and an encapsulant cover layer, wherein the encapsulant cover layer essentially fixates the overlaps of the wiring elements with respect to the respective back terminals.

## Description

### TECHNICAL FIELD AND BACKGROUND

The present disclosure relates to a 3D formed photovoltaic solar panel, in particular to a free-formable semi-finished or semi-manufactured photovoltaic module for a 3D formed solar panel, and to a method for manufacturing thereof.

As is known photovoltaic panels suitable for installation on roofs, agricultural or maritime installations and similar, typically have a planar, rigid structure in standardized size. Such panels are typically manufactured by assembling a number of photovoltaic cells in a predefined arrangement. The cells within the panel are electrically interconnected in a number of possible electrical string configurations. For protection, e.g. against weather conditions, the sensitive components in the panel are typically sandwiched between protective sheets e.g. front and back sheets. Like the panels, the cells are typically available in a limited number of sizes. This limits possibilities of manufacturing a solar panel according to a customized size. Further, as the cells, are typically formed of a rigid material, possibilities in manufacturing of panels in a desired three-dimensional shape remain limited.

Flexible, or bendable solar cells have become commercially available. Known flexible cells include thin film PV cells as copper indium gallium selenide solar cells (or CIGS). A CIGS cell is manufactured by depositing a thin layer of copper, indium, gallium and selenium on a backing substrate along with electrodes on the front and back to collect current. Alternative thin-film PV technologies include cadmium telluride and amorphous silicon. Application of thin films in combination with a use of a flexible substrate allows the cells to be flexible, e.g. bendable, along one axis. Like cells based on rigid PV material, such as polycrystalline silicon, thin film PV cells comprising a plurality of electrically interconnected cells, are typically available in a limited number of sizes and geometries, usually aimed at manufacturing of photovoltaic panels suitable for installation on roofs. Flexible thin film PV cells typically have one polarity electrode on the front side, e.g. the light receiving side, connected to a front current collection electrode, whereas the other polarity electrode is provided on the back side, e.g. in the form of a conductive flexible substrate. In order to facilitate electrical interconnection between adjacent thin film PV cells, the front and back electrodes are typically provided in a shingle-type arrangement in which an electrical interconnection between adjacent cells may be formed by overlaying a back electrode of one cell on front electrode of an adjacent cell. This allows the formation of PV installations covering large surface areas such on roofs. By virtue of the flexibility of the thin film PV cells, such shingle-type arrangements may be bendable e.g., for example, to follow a 2D-curvature of a roof. However, its flexibility remains limited, both in terms of dimensioning as the arrangements are provided in a limited number of dimensions, as in terms of formability in three dimensions. Accordingly, there remains a need for PV solar panels which are dimensioned and formed according to custom 3D geometries.

WO2018077849 relates to a photovoltaic panel having a flexible structure and to a method of manufacturing thereof. Formed panels comprise a plurality of photovoltaic cells, a support and a protection structure. The support and protection structure defines a plurality of laterally separated encapsulation positions at which the photovoltaic cells are arranged. The panel in WO2018077849 is formed by PV cells that are supported on a support and protection structure that imposes stringent requirements on positioning accuracy during manufacturing. The support and protection structure further comprises holes and flexible connection portions adapted to connect the encapsulation positions. By virtue of the flexible connection portions the panel may be bent along one of at least two perpendicular axes. Further, given the flexible nature of the connection portions, a support structure is required to maintain a bending or flexing position of an installed panel.

The present invention aims to mitigate at least one of the above or other disadvantages.

### SUMMARY

Aspects of the present disclosure relate to a method for manufacturing a semi-finished photovoltaic module. Said semi-finished module may be used in the manufacturing of 3D formed solar panels, e.g. panels having a curvature along at least one, preferably at least two orthogonal directions. The method comprises providing a plurality of flexible photovoltaic elements. Each flexible photovoltaic element comprises a thin film photovoltaic stack disposed on a flexible carrier; a first polarity back terminal stretching out along a first portion of a back surface of the flexible photovoltaic element, the first polarity back terminal electrically connected to the first polarity electrode of the thin photovoltaic stack. Each flexible photovoltaic element further comprises a second polarity front terminal including a front current collecting element disposed along a light receiving front surface of the photovoltaic stack, the front current collecting element having side-portions laterally protruding across a side of the photovoltaic stack to form a front contactable second polarity front terminal. The method further includes: folding the laterally protruding side-portions at least in part back along the back surface of the flexible photovoltaic element to form a back contactable second polarity back terminal. By folding the laterally protruding side-portions at least in part back along the back surface of the flexible photovoltaic element a back contactable second polarity back terminal can be formed. By forming a back contactable second polarity back terminal the photovoltaic element can be electrically contacted from one side, e.g. the photovoltaic element can be a fully back contactable element. Advantageously this allows electrically contacting both polarity electrodes of the PV cell (thin film photovoltaic stack) from a backside, i.e. opposite the light receiving front side. By contacting both terminals from a single side vias or electrical loop throughs, i.e. wiring running through a sheet (e.g. an encapsulation sheet) may be avoided. Provision of a fully back contactable flexible photovoltaic element greatly simplifies manufacturing of a flexible panel including a plurality of electrically interconnected elements. Avoiding a need for vias may reduce complexity, e.g. positioning accuracy, during assembly of a panel comprising such flexible photovoltaic elements.

The method also includes the steps of: disposing or placing a plurality of flexible electrically conductive wiring elements in a predefined pattern. The pattern is preferably adapted to match a layout of the plurality flexible photovoltaic elements comprised in the semi-finished free-formable photovoltaic module ; and the step of placing the plurality of back contactable flexible photovoltaic elements. The plurality of back contactable flexible photovoltaic element is preferably placed in a layout matching the predefined pattern such that the first and second polarity back terminals have an overlap with the respective flexible conductive wiring elements. The larger the overlap the better an electrical interconnection between wiring element and the photovoltaic element may be.

After placing the wiring and flexible photovoltaic elements the disposed flexible electrically conductive wiring elements and the placed flexible photovoltaic elements are encapsulated with an encapsulant to form an encapsulant cover layer. Advantageously, the encapsulant cover layer fixates a relative position of the plurality of laterally separated flexible photovoltaic element and the plurality of flexible electrically conductive wiring elements, thus forming and/or fixing an electrically conductive interconnection between adjacent flexible photovoltaic elements. The electrically conductive interconnection may advantageously be formed by direct mechanical contact between the wiring elements and the respective flexible photovoltaic elements. By fixating the mechanical contact between the wiring elements and the respective flexible photovoltaic elements separate soldering steps can be avoided. Optionally or in addition, a conduction promotor, e.g. a conductive paste, may be provided between the wiring elements and the flexible photovoltaic element. Optionally or in addition, an electrically conductive adhesive (glue), may be provided between the wiring and the flexible photovoltaic element. The electrically conductive glue may improve the mechanical and/or electrically conductive interconnection between a wiring element and a flexible photovoltaic element. Further, the glue and/or conduction promotor may maintain a relative position of the wiring element and the flexible photovoltaic element during manufacturing, e.g. before the encapsulation step.

In addition to fixing the position of the elements the encapsulant serves as a bonding means for integration the semi-finished free-formable photovoltaic module in a finished product, e.g. a 3D formed solar panel including one or more additional layers such as a top- or bottom barrier layers.

Encapsulation preferably includes lamination, e.g. vacuum lamination or roll lamination. By application of heat and/or pressure the softened encapsulant may flow over and/or around the wiring element and the flexible photovoltaic element to form an encapsulant cover layer. The encapsulant is preferably provided in a form of encapsulation layers, e.g. encapsulant sheets, i.e. the encapsulant cover is preferably formed of an encapsulant top sheet and encapsulant bottom sheet fused thereto. It will be appreciated that encapsulant materials and encapsulant sheets are known in the field. Optionally, further components, e.g. back-side contactable electronic components such as diodes or power optimizers, may be included.

In one embodiment, the manufacturing method comprises providing an encapsulant bottom and top sheet. In a preferred embodiment, the plurality of flexible electrically conductive wiring elements are disposed or placed onto an encapsulant sheet, e.g. the bottom sheet. The back contactable flexible photovoltaic elements are subsequently placed onto said sheet with the contact terminals facing the respective wiring elements. After placing the wiring elements, and optional further components, a top encapsulant layer, e.g. sheet, may provided to cover the components. It will be appreciated the semi-finished free-formable photovoltaic module may alternatively be assembled in a reverse order, e.g. by: placing the back contactable flexible photovoltaic elements with their respective light receiving side onto a top encapsulant sheet; placing the wiring elements onto the back contact terminals; and placing a bottom encapsulant cover sheet. Alternatively, the components (wiring elements, flexible photovoltaic elements and optional further components) may be placed or disposed on a single, comparatively thicker encapsulant layer, which is suitably selected to have a thickness which, upon lamination, allows encapsulation of the components.

In some embodiments, the laterally protruding side portions may be looping side portions, e.g. of a wire or similar printed structure forming the front current collecting element. Inventors found that looping side portions of a wire laterally protruding beyond an edge of the light receiving surface of a flexible photovoltaic element may be particularly suitable to form a back contactable terminal by folding of said portions.

In a preferred embodiment, disposing and/or placing is performed by a pick-and-place tool, preferably a programmable pick-and-place tool. In a preferred embodiment the pick-and-place tool may be arranged to pick up the various components of the semi-finished free-formable photovoltaic module, such as the wiring elements, the flexible photovoltaic elements and/or the encapsulation layers, by means of vacuum suction. By releasing a vacuum condition the respective elements may be released, e.g. deposited, according to said predefined pattern.

The electrically conductive wiring elements are preferably formed of thin conductive films, e.g. metal foils and/or conductive tape, e.g. carbonaceous or copper tape. Preferably, the electrically conductive wiring have a thickness less than 200 pm, e.g. 50 pm or less such as 6 pm. The thinner the wiring the more flexible the semi-finished free-formable photovoltaic module can be. Optionally, the electrically conductive wiring elements or parts thereof may be formed by evaporated or deposited conductive tracks.

Preferably, the flexible photovoltaic elements each are each bendable along an axis with a bending radius of curvature in a range below 25 cm without essentially loosing functionality, preferably they are bendable with a smaller radius of curvature, e.g. below 10 cm. The smaller the bending radius, the more flexible the free-formable semi-finished free-formable photovoltaic module can be and the more sharply curved the 3D solar panel formed therewith can be. It will be appreciated that there is no principal reason for a lower limit. In practice the lower limit may be determined by an availability, e.g. commercial availability of suitable flexible photovoltaic elements. Inventors found flexible photovoltaic element having a bending radius in a range between 1 mm and 10 cm to be particularly suitable.

In addition, the lateral spacing between adjacent flexible photovoltaic element can allow deformation, e.g. flexing of the semi-finished free-formable photovoltaic module along two orthogonal directions. For example, a semi-finished free-formable photovoltaic module can be formed in a desired three dimensional shape by heating the semi-finished free-formable photovoltaic module in a mould. Presence of encapsulant and/or absence of continuous stiff elements, e.g. conductive bars or crystalline Si cells, allows the semi-finished free-formable photovoltaic module to be modelled in a desired three dimensional shape.

In some preferred embodiments, an isolating layer, e.g. insulator sheet, is provided between the back surface of the flexible photovoltaic element and the second polarity back terminal. This isolating layer can electrically isolate the second polarity back terminal from the carrier and/or the first polarity back terminal to prevent short circuits. Said isolating layer may be suitably provided by a polymer sheet, e.g. a plastic sheet. Preferably, said isolating layer is an adhesive tape, e.g. an electrically insulating adhesive, e.g. a double sided tape or glue layer. An electrically insulating adhesive may advantageously provide electrical insulation and fixate a positon of the second polarity terminal, e.g. the folded laterally protruding side-portions.

In other or further preferred embodiments, the method comprises providing an electrically conductive sheet to the first and/or second polarity back terminal to increase a contactable area of the respective back terminal(s). Said electrically conductive sheet may be affixed to the respective back terminal, e.g. by a conductive adhesive. Increasing the contactable area of the respective back terminals can enlarge an area of the overlap. In preferred embodiments at least the contactable area of second polarity back terminal is enlarged, e.g. the terminal formed with the back-folded laterally protruding side portions of the flexible photovoltaic element. The larger the area of overlap the better the electrical contact between the wiring elements and contact terminal may be.

Further aspects of the present disclosure relate to a semi-finished free-formable photovoltaic module obtained by the disclosed manufacturing method. The semi-finished free-formable photovoltaic module comprises a plurality of laterally spaced flexible photovoltaic elements, each flexible photovoltaic element adapted to provide electric power when illuminated by a light irradiation on a light receiving front side. Each flexible photovoltaic element comprises: a thin film photovoltaic stack disposed on a flexible carrier; a first polarity back terminal stretching out along a first portion of a back surface of the flexible photovoltaic element, the first polarity back terminal electrically connected to a first polarity electrode of the thin photovoltaic solar stack; a second polarity front terminal including a front current collecting element disposed along the light receiving front surface of the photovoltaic stack, the front current collecting element having side-portions laterally protruding across a side of the photovoltaic stack and wherein the side portions are at least in part folded back along the back surface of the flexible carrier to form a second polarity back terminal; and a plurality of flexible electrically conductive wiring elements. The flexible electrically conductive wiring elements forming electrically conductive interconnections between adjacent flexible photovoltaic elements. Each wiring element having an overlap with the respective back terminals of adjacent flexible photovoltaic elements; and an encapsulant cover layer covering the plurality of laterally spaced flexible photovoltaic elements and the plurality of flexible electrically conductive wiring elements. Said encapsulant cover layer essentially fixating the overlaps of the wiring elements with respect to the respective back terminals.

Yet further aspects of the present disclosure relate to a method for making a 3D formed solar panel and to a 3D formed solar panel obtainable by said method. The 3D formed solar panel comprises a semi-finished free-formable photovoltaic module according to the invention and/or a semi-finished free-formable photovoltaic module obtained by the method according to the invention. The method for making a 3D formed solar panel comprises moulding, e.g. pressure moulding, a semi-finished free-formable photovoltaic module according to the invention into a pre-defined 3D geometry.

### BRIEF DESCRIPTION OF DRAWINGS

These and other features, aspects, and advantages of the apparatus, systems and methods of the present disclosure will become better understood from the following description, appended claims, and accompanying drawing wherein:
FIG 1 depicts a perspective top view photograph of a semi-finished free-formable photovoltaic module;
FIG 2A depicts a schematic cross-section side view of a semi-finished free-formable photovoltaic module ;
FIG 2B depicts a schematic cross-section side view of a semi-finished free-formable photovoltaic module;
FIG 3A depicts a schematic cross-section side view of an embodiment of a flexible photovoltaic element;
FIG 3B depicts a schematic cross-section side view of an embodiment of a flexible photovoltaic element;
FIG 3C depicts a schematic cross-section side view of an embodiment of a flexible photovoltaic element;
FIG 4A depicts a photograph of a light receiving side of an embodiment of a flexible photovoltaic elementincluding a front contactable terminal;
FIG 4B depicts a photograph of a back side of an embodiment of a flexible photovoltaic element;
FIG 4C depicts a photograph of a light receiving side of an embodiment of a flexible photovoltaic elementwherein the front contactable terminal is folded to the backside;
FIG 4D schematically illustrates a back side of an embodiment of a flexible photovoltaic elementhaving back contactable first and second polarity terminals;
FIG 5A schematically illustrates bottom-views of an embodiment of a wiring layout (left) and wiring layout including flexible photovoltaic elements (right);
FIG 5B schematically illustrates bottom-views of an embodiment of a wiring layout (left) and wiring layout including flexible photovoltaic elements (right);
FIG 5C schematically illustrate a detailed bottom-view of an embodiment of an electrical interconnection between adjacent flexible photovoltaic elements;
FIG 6A and 6B depict top-view photographs of an embodiment of a semi-finished free-formable photovoltaic module at various stages of its manufacturing;
FIG 7A provides a schematic representation of the manufacturing method,
FIG 7B provides photographs of flexible electrically conductive wiring elements and electrically interconnected flexible photovoltaic elements, and
FIG 8 schematically illustrates an embodiment of a semi-finished free-formable photovoltaic module (top) and a 3D formed solar panel including the semi-finished free-formable photovoltaic module (bottom).

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

The term panel or solar panel as used herein does not necessarily imply a presence or an exclusion of a frame. In some embodiments a solar panel, e.g. a 3D formed solar panel, with the semi-finished free-formable photovoltaic module may be supported by a frame. In other embodiments the semi-finished free-formable photovoltaic module may be shaped, e.g. moulded, in to a 3D formed solar panel, e.g. along a pre-formed support structure, e.g. a front or back cover. According to the invention there is provided a semi-finished free-formable photovoltaic module which may be flexed and/or stretched, along two orthogonal directions (bi-axially) without essentially losing functionality.

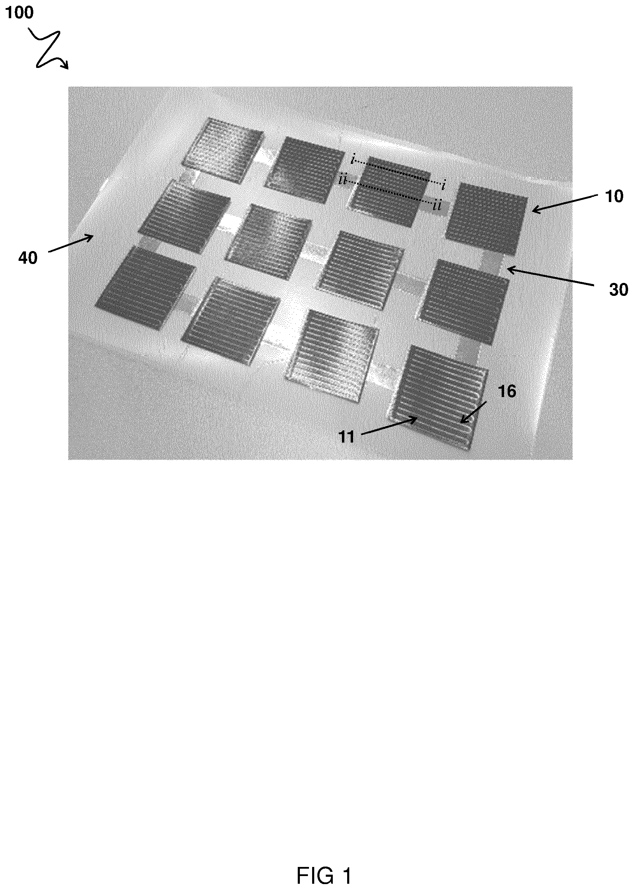

FIG 1 depicts a perspective top view photograph of a semi-finished free-formable photovoltaic module 100 for a 3D formed solar panel. The embodiment as shown comprises a plurality of laterally separated flexible photovoltaic elements and a plurality of flexible electrically conductive wiring elements 30. As shown, adjacent flexible photovoltaic elements 10 are electrically connected by a flexible electrically conductive wiring element. The electrical connection between flexible electrically conductive wiring element 30 and the flexible photovoltaic element 10 will be described in more detail later. In the particular embodiment as shown an array of three by four flexible photovoltaic elements are electrically interconnected in three parallel strings of each four elements. Covering the flexible photovoltaic elements 10 and the flexible electrically conductive wiring elements 30 is an encapsulant cover layer 40. In the embodiment as shown the encapsulant cover layer 40 is formed of an encapsulant top sheet and encapsulant bottom sheet fused thereto. Also indicated in the figure are the front current collecting element 16 and thin film photovoltaic stack 11 of the flexible photovoltaic elements 10.

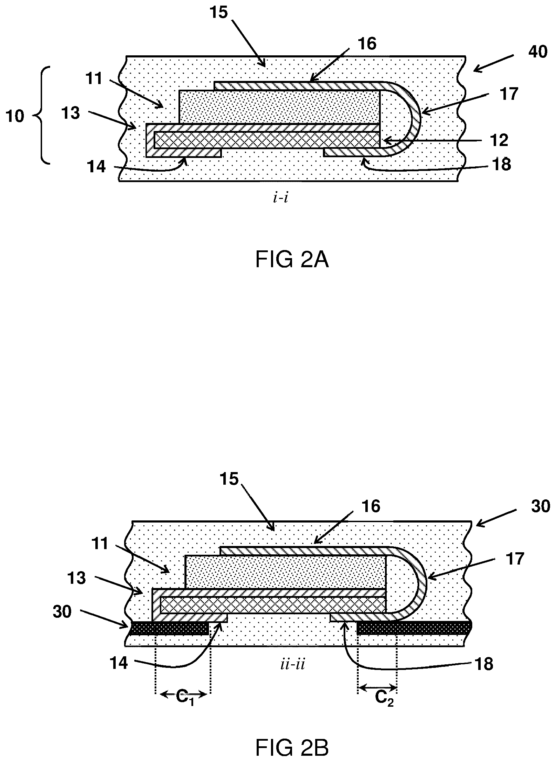

FIG 2A depicts a schematic cross-section side view of the semi-finished free-formable photovoltaic module shown in FIG 1 along line i-i. The cross section side view depicts a flexible photovoltaic element10 comprising a thin film photovoltaic stack 11 provided on a flexible substrate 12. Note that the light receiving side of the flexible photovoltaic element 10 is displayed facing an upward direction. Connected to the thin film photovoltaic stack 11: a second polarity front terminal 15 formed by a front current collecting element 16 having laterally protruding side-portions 17; and a back current collecting element 13 connected to a first polarity back terminal 14. The laterally protruding side-portions 17 of the front current collecting element 16 are folded back around the carrier 12 to form a back contactable second polarity back terminal 18 adjacent to the first polarity back terminal 14. An encapsulant cover layer 40 encloses the various elements and maintains a relative position between the elements. FIG 2B depicts a schematic cross-section side view of the same semi-finished free-formable photovoltaic module for a 3D formed solar panel but now along line ii-ii. Additionally visible are portions of two flexible electrically conductive wiring elements 30 respectively contacting the first polarity back terminal 14 and the second polarity back terminal 18. Electrical connection between the wiring elements 30 and the first polarity back terminal 14 or the back contactable second polarity back terminal 18, respectively, is provided by a respective overlap having a length indicated C₁ and C₂ respectively.

It will be appreciated that there are no principal limits to a minimum and/or maximum size of the flexible photovoltaic elements. A minimum or maximum size may depend on an availability, e.g. a commercial availability, of available flexible photovoltaic elements. Likewise, it will be appreciated that there are no principal limits to a minimum and/or maximum separation between neighboring photovoltaic elements. Smaller photovoltaic elements and/or larger separations may improve flexibility of the semi-finished free-formable photovoltaic module along that direction. Larger flexible photovoltaic elements and/or smaller separations may improve a light harvesting power output per unit area. Inventors found particularly suitable flexible photovoltaic elements to have a dimension, e.g. a length, in a range between about four and about twenty centimeters, preferably in a range between about five and about fifteen centimeters, e.g. about seven centimeters or about ten centimeters. A separation distance between neighboring flexible photovoltaic elements between about two and about thirty millimeters, preferably between about five and about fifteen millimeters, e.g. about ten millimeters, was found to provide a good trade-off between a desired flexibility and power output. likewise, it will be appreciated that there are no principal limits to a minimum and/or maximum overlap between wiring elements and the back terminals. Inventors found, that sufficient electrical conductivity (i.e. a contact resistance below 10Ω, or less, e.g. below 1 Ohm, or even less, e.g. below 10 or 100 milliohm may be obtained for overlaps having a total area larger than one cm². For a flexible photovoltaic element having a width of five centimeter a corresponding minimum overlap distance may be calculated to be two millimeter.

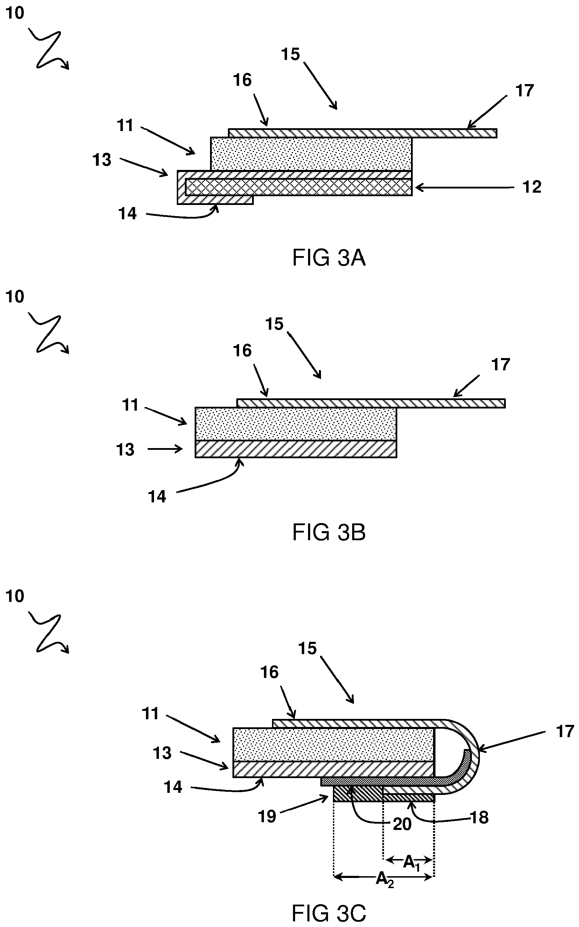

FIG 3A depicts a schematic cross-section side view of an embodiment of a flexible photovoltaic element 10 having its laterally protruding side-portions 17 of the front terminal 15 in an unfolded position. In some embodiments, e.g. as shown, the first polarity back terminal 14 is likewise formed of portions of a first polarity back current collection element 13 folded back around the flexible carrier. Alternatively the first polarity back terminal 14 may be connected to the first polarity back current collection element 13 by other means, e.g. by a via (not shown) or specific wire or track (not shown).

In a preferred embodiment, e.g. as shown in FIG 3B, the flexible carrier 12 may form the back current collection element 13 and/or the first polarity back terminal 14. For example, the flexible carrier 12 may be formed of a conducive composition, e.g. a thin metal sheet.

Directly folding the protruding side-portions 17 of the front current collecting element 16 around onto a conductive flexible carrier may lead to electrical shorts. Accordingly, in a preferred embodiment an insulator sheet 20 is provided between the back surface of the flexible photovoltaic element, e.g. the first polarity back terminal 14 , and the second polarity back terminal. FIG 3C depicts a schematic cross-section side view of an embodiment of a flexible photovoltaic element including an insulator sheet 20 that is provided between the first polarity back terminal 14, and the second polarity back terminal.

In other or further preferred embodiments, there is provided an electrically conductive sheet 19 to the first and/or second polarity back terminal. By providing an electrically conductive sheet a contactable area of the respective back terminal can be enlarged. FIG 3C depicts a schematic cross-section side view of an embodiment of a flexible photovoltaic element including an electrically conductive sheet connected to the folded back side-portions 17 of the front current collecting element 16. By providing the electrically conductive sheet 19 the contactable area of the back contactable second polarity back terminal 18 is enlarged from an area A1 (without electrically conductive sheet) to an area A2 (with electrically conductive sheet). Preferably, the first and second polarity back terminal have a contactable area of at least four square centimeters or more e.g. ten square centimeters. The larger the contact area the less positioning accuracy, e.g. of the pick-and-place tool that is required to make electrical contact. The larger the contact area the more freedom in relative positioning of the wiring elements with respect to the flexible photovoltaic element. Preferably, the contact areas of the first and second polarity terminals are of about equal area. Preferably, the first and second polarity terminals are approximately symmetrical. Advantageously, provision of about equal area terminals and/or provision of symmetrical terminals can further reduce manufacturing complexity. For example, an increased positional tolerance when placing the cells on the pre-defined wiring pattern. Reduce manufacturing complexity, e.g. relaxed tolerances for a pick-and-place machine, can be particularly beneficial for large scale production.

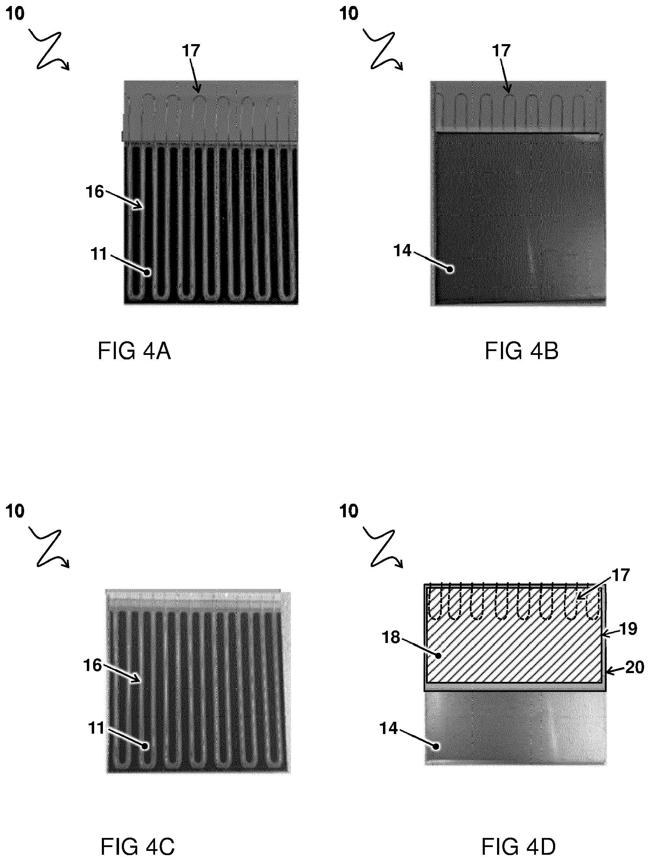

FIGs 4A-D provide top and bottom view images of an embodiment of a flexible photovoltaic element having a thin film photovoltaic stack 11 and a front current collecting element 16 including laterally side-portions 17. In the embodiment as shown, the side-portions 17 are formed by a portions of looping wire. FIG 4A depicts a photograph of a light receiving side of such embodiment having its side-portions 17 in an unbent state. FIG 4B depicts a photograph of a back side of the same embodiment. Visible is a first polarity back terminal 14 stretching essentially across the whole of the back surface of said flexible photovoltaic element. In some embodiment, e.g. as shown, the first polarity back terminal 14 forms the flexible carrier. FIG 4C depicts a photograph of a light receiving side of an embodiment of a flexible photovoltaic element wherein the front contactable terminal is folded to the backside. FIG 4D schematically illustrates a back side of an embodiment of a flexible photovoltaic element having back contactable first and second polarity terminals (14,18). The position of the folded-back side-portions 17 of the front current collecting element are indicated by dashed lines. Contacting the side-portions 17 is an electrically conductive sheet 19, forming an enlarged back contactable second polarity back terminal 18. Separating the first and second polarity back terminals is an insulator sheet 20.

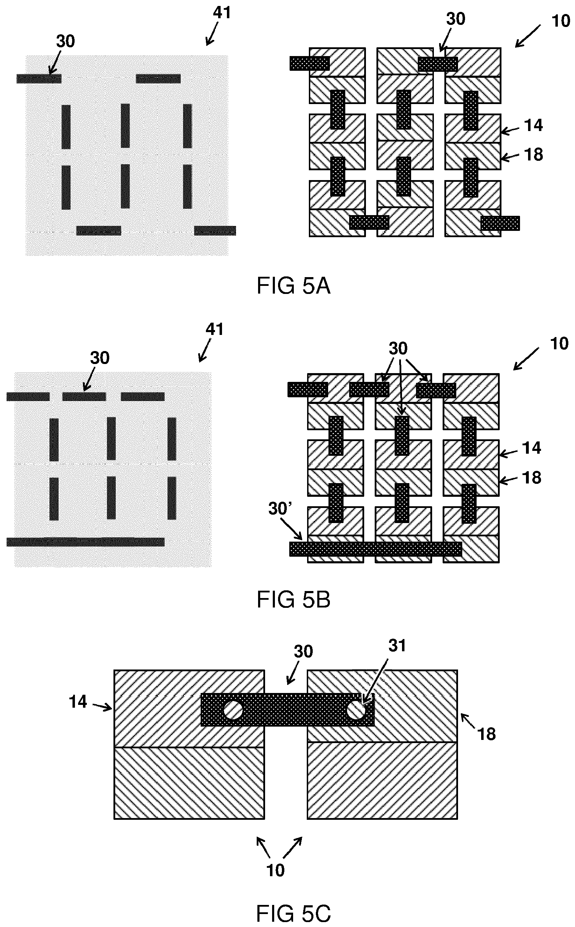

Now, with reference to FIGs 5A-B the placing and pattern of the flexible electrically conductive wiring elements 30 and flexible photovoltaic elements 10 will be explained. As explained an electrical connection between a terminal of a flexible photovoltaic element and a flexible electrically conductive wiring element can be formed by direct mechanical contact, e.g. through an overlapping contact area. By placing flexible electrically conductive wiring elements 30 having a suitable length an electrical connection may be formed between adjacent (laterally spaced) flexible photovoltaic elements 10. By contacting a first polarity terminal of a first flexible photovoltaic element to a second polarity terminal of a second flexible photovoltaic element said elements may contacted in series. FIG 5A schematically illustrates bottom-views of an embodiment of a wiring layout (left) on a placed on a bottom encapsulation sheet 41 and wiring layout that wiring layout including flexible photovoltaic elements (right). The flexible electrically conductive wiring elements 30 are arranged such that an wiring element interconnects a first polarity back terminal 14 of one element with second polarity back terminal 18 of an adjacent element. In the embodiments as shown a total of nine elements are interconnected in series in one string. It will be appreciated that other electrical connections or string designs, e.g. having a different number of photovoltaic elements and/or including parallels strings are also envisioned, e.g. by interconnecting same polarity terminals of adjacent flexible photovoltaic elements, e.g. as shown in FIG 5B. When connecting same polarity terminals of adjacent flexible photovoltaic elements the respective wiring may be formed of a plurality of individual wiring elements and/or by a longer continuous wiring element 30' interconnecting a plurality of adjacent flexible photovoltaic elements, e.g. as shown.

FIG 5C schematically illustrate a detailed bottom-view of an embodiment of an electrical interconnection between adjacent flexible photovoltaic elements . In some preferred embodiments, e.g. as shown, cutouts 31 are provided to the flexible electrically conductive wiring element 30 electrically interconnecting a first polarity back terminal 14 of a flexible photovoltaic element 10 to a second polarity back terminal 18 of an adjacent flexible photovoltaic element. The cutouts 31 are provided to the flexible electrically conductive wiring elements 30 at a position overlapping the flexible photovoltaic element 10. Inventors found that by providing cutouts at an overlap position fixation between the wiring element and the flexible photovoltaic element may be improved. The cutouts allow encapsulant to penetrate the aperture to contact the terminal. As such, the cutouts can improve mechanical contact and accordingly improve electrical contact between a flexible photovoltaic element and wiring. Improved adhesion between the flexible electrically conductive wiring element and the flexible photovoltaic elements 10 can further mitigate shifting, e.g. lateral shifting, between these elements, e.g. during manufacturing of a 3D formed solar panel comprising a semi-finished free-formable photovoltaic module according to the invention. It will be appreciated that the cutouts need not necessarily be of the depicted circular shape, any shape can be used. The cutouts may also be provided along the perimeter of the wiring elements.

In some preferred embodiments, e.g. as shown in FIGs 5A (left) and 5B (left) the flexible electrically conductive wiring elements 30 are disposed on an encapsulant bottom sheet 41 and the disposed electrically conductive wiring elements are affixed thereto in a heating step prior to placing the plurality of flexible photovoltaic elements. This allows preparing an encapsulant sheet with pre-placed wiring elements, e.g. allows preparing a stock of encapsulant sheets with pre-placed wiring elements. The flexible photovoltaic elements may be added in a separate manufacturing step, e.g. a spatially and/or temporally separated manufacturing step. By preparing an encapsulant sheet with pre-placed wiring elements handling of flexible photovoltaic elements , which are typically moisture sensitive may be postponed, resulting in a reduced exposure of the flexible photovoltaic elements to moisture during manufacturing.

Advantageously the disclosed method is not limited to using flexible photovoltaic elements of a fixed dimension, e.g. a fixed commercially available dimension. In preferred embodiment, a flexible photovoltaic element, or the plurality of flexible photovoltaic elements 10 can be sized by cutting a donor flexible photovoltaic element.. For example, a donor flexible photovoltaic element having a dimension of about thirty by about seven centimeters may be cut into four smaller elements 10 of about seven by about seven centimeters. Cutting of a large donor flexible photovoltaic element into smaller elements increases flexibility in manufacturing and/or designing of semi-finished free-formable photovoltaic modules for complex 3D formed solar panels.

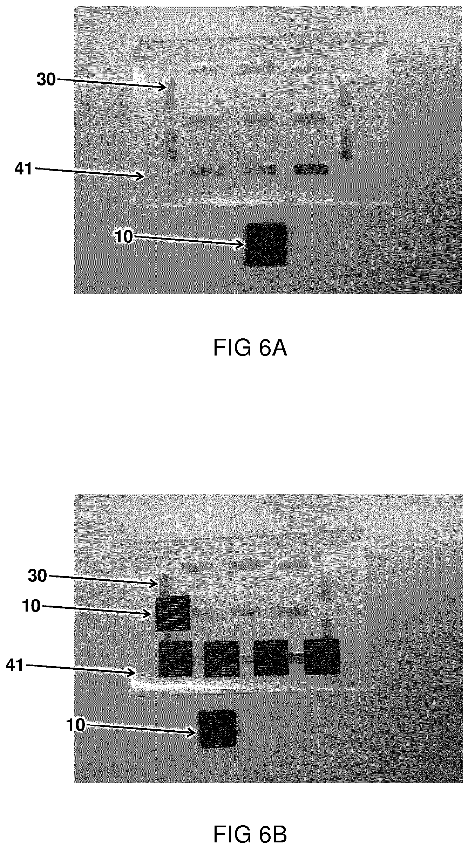

FIGs 6A and 6B depict top-view photographs of an embodiment of a semi-finished free-formable photovoltaic module at various stages during its manufacturing. Depicted in FIG 6A is an encapsulant bottom sheet 41 onto which a plurality of flexible electrically conductive wiring elements 30 are placed. The flexible electrically conductive wiring elements 30 are affixed to the sheet by a thermal treatment causing encapsulant to soften. Visible besides the encapsulant bottom sheet is a stack of back contactable flexible photovoltaic elements. FIG 6B depicts the same embodiment of a semi-finished free-formable photovoltaic module after five flexible photovoltaic elements 10 are placed onto the corresponding wiring elements.

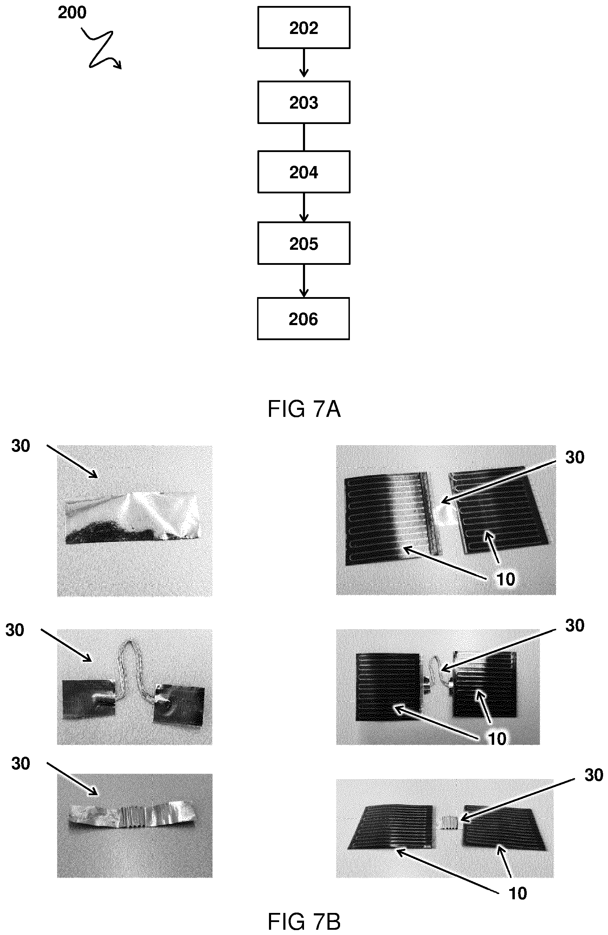

FIG 7A schematically illustrates the manufacturing method 200. As described above the method 200 for manufacturing a semi-finished free-formable photovoltaic module for a 3D formed solar panel 100 comprises: providing 202 a plurality of flexible photovoltaic elements 10; folding 203 the laterally protruding side-portions at least in part back along the back surface of the flexible photovoltaic element to form a back contactable second polarity back terminal 18; disposing 204 a plurality of flexible electrically conductive wiring elements 30 in a pattern adapted to match a layout of the plurality of photovoltaic elements comprised in the semi-finished free-formable photovoltaic module 100; placing 205 the plurality of flexible photovoltaic elements 10 in a layout matching the pattern P such that the first and second polarity back terminals have an overlap with the respective conductive wiring elements; and encapsulating (206) the disposed flexible electrically conductive wiring elements and the placed flexible photovoltaic elements.

The electrically conductive wiring elements are preferably formed of thin conductive contact strips or foils, e.g. metal foils and/or conductive tape, e.g. carbonaceous or copper tape. The more flexible and/or stretchable the electrical interconnects between the flexible photovoltaic elements 10, the more flexible and/or the better formable the semi-finished free-formable photovoltaic module (100) can be without essentially loosing functionality. In a preferred embodiment, the electrically conductive wiring element is a piece or strip, e.g. a rectangular strip, of an electrically conducting foil metal. In another or further preferred embodiment, the electrically conductive wiring element is a meandering element, e.g. a meandering strip or wire. In some preferred embodiments, the electrically conductive wiring element includes a bellow section, e.g. a flat bellow.

FIG 7B (top) depicts photographs (left) of an electrical interconnect formed by a strip of aluminum foil and (right) two flexible photovoltaic elements 10 electrically interconnected with by a strip of aluminum foil. FIG 7B (center) depicts photographs (left) of an electrical interconnect formed by an electrically conductive meandering strip and (right) two flexible photovoltaic elements 10 electrically interconnected with a meandering electrical interconnect. FIG 7B (bottom) depicts photographs (left) of an electrical interconnect formed by an electrically flat bellow and (right) two flexible photovoltaic elements 10 electrically interconnected with a flat bellow.

It will be appreciated that, as explained herein, the method may not be limited to the depicted schematic steps. For example, the method may include provision of one encapsulation sheet, or include provision of a encapsulation bottom and top sheet. Further the method may include provision of insulator, conductive sheet and/or adhesive layers. Further, the method may include provision of one or more cutouts to the flexible electrically conductive wiring elements. Further, unless otherwise specified, the steps may performed in alternate orders and/or separated into multiple steps. For example, as explained the flexible electrically conductive wiring elements may be affixed to a encapsulant bottom sheet 30 in a separate heating step.

Further aspects of the present disclosure relate to a semi-finished free-formable photovoltaic module for a 3D formed solar panel obtained by any one or more of the disclosed manufacturing steps or methods disclosed. Accordingly, the present disclosure relates to a semi-finished free-formable photovoltaic module , e.g. as shown in FIG 1. The semi-finished free-formable photovoltaic module comprising:
- a plurality of laterally spaced flexible photovoltaic elements 10, each flexible photovoltaic element 10 adapted to provide electric power when illuminated by a light irradiation on a light receiving front side, each flexible photovoltaic element 10 comprising:
   o a thin film photovoltaic stack 11 disposed on a flexible carrier 12;
   o a first polarity back terminal 14 stretching out along a first portion of a back surface of the flexible photovoltaic element 10;
   o a second polarity front terminal including a front current collecting element 16 disposed along the light receiving front surface of the photovoltaic stack, the front current collecting element having side-portions 17 laterally protruding across a side of the photovoltaic stack and
   wherein the side portions are at least in part folded back along the back surface of the flexible carrier to form a second polarity back terminal 18; and
- a plurality of flexible electrically conductive wiring elements 30 forming an electrically conductive interconnection between adjacent flexible photovoltaic elements, each wiring element having an overlap with the respective back terminals of adjacent flexible photovoltaic elements 10; and
- an encapsulant cover layer 40 covering the plurality of laterally spaced flexible photovoltaic elements 10 and the plurality of flexible electrically conductive wiring elements and wherein the encapsulant cover layer essentially fixates the overlaps of the wiring elements with respect to the respective back terminals.

The semi-finished free-formable photovoltaic module 100 may include any of the features or elements as described herein above in relation its manufacturing method. For example, in a preferred embodiment the semi-finished free-formable photovoltaic module includes an insulator sheet 20 provided between the back surface of the flexible photovoltaic element and the second polarity back terminal. In another or further preferred embodiment, the first and/or second polarity back terminal of flexible photovoltaic element 10 is electrically connected to a conductive sheet 19 stretching out along a portion of the back surface to enlarge a contactable area of the respective back terminal. In yet another or further preferred embodiment of the semi-finished free-formable photovoltaic module the electrically conductive wiring elements are provided with cutouts 31 at the overlaps to improve fixation between the wiring element and the flexible photovoltaic element.

Yet further aspects of the present disclosure relate to a method for making a 3D formed solar panel and to a 3D formed solar panel obtainable by said method. The 3D formed solar panel comprising a semi-finished free-formable photovoltaic module according to the invention and/or comprising a semi-finished free-formable photovoltaic module obtained by the method according to the invention. The method for making a 3D formed solar panel comprises moulding, e.g. pressure moulding, a semi-finished free-formable photovoltaic module according to the invention to a pre-defined 3D geometry.

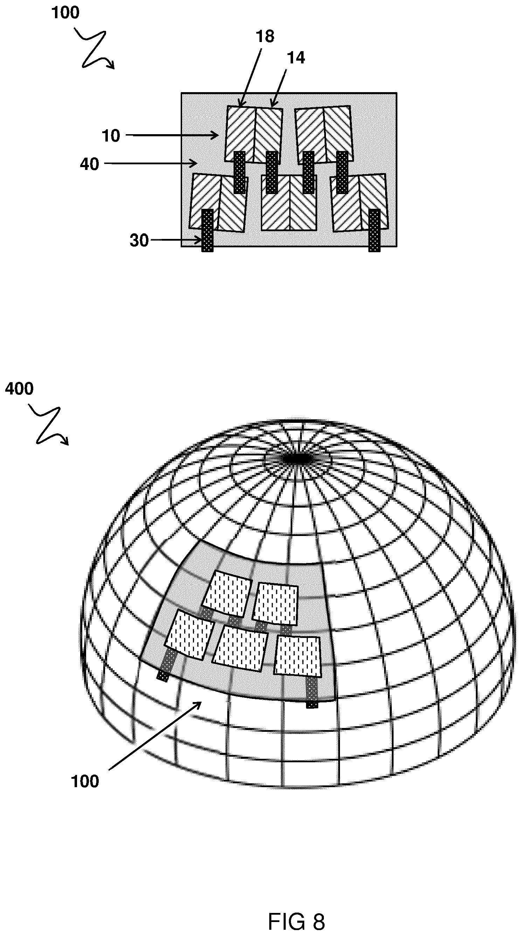

FIG 8 schematically illustrates an embodiment of a semi-finished free-formable photovoltaic module (top) and a 3D formed solar panel including the semi-finished free-formable photovoltaic module (bottom). In the exemplary 3D formed solar panel 400, as shown, the panel is curved along two orthogonal directions. Its shape being adapted to match an outer surface of a dome-shaped structure. The method for making a 3D formed solar panel includes providing a semi-finished free-formable photovoltaic module. The semi-finished free-formable photovoltaic module may be obtained by any of the manufacturing methods described herein. The particular semi-finished free-formable photovoltaic module 100 as shown includes five flexible photovoltaic elements 10. Each flexible photovoltaic element having a back contactable first polarity back terminal 14 and a second polarity back terminal 18. Flexible electrically conductive wiring elements 30 interconnect the flexible photovoltaic elements in a string. At the end of the string free ends of two flexible electrically conductive wiring elements 30 remain accessible. As the semi-finished free-formable photovoltaic module 100 is intended to be formed into a 3D curved shape the modules may be designed according to a matching pre-defined arrangement. In the exemplary embodiment as shown the outer flexible photovoltaic elements are slightly tilted. The semi-finished free-formable photovoltaic module 100 is pressure moulded, e.g. in a cavity having a suitable curvature. Heating the semi-finished free-formable photovoltaic 100 to above a softening temperature of the encapsulant allows shaping the semi-finished free-formable photovoltaic module into the desired 3D geometry. Slight tilting of the flexible photovoltaic elements in semi-finished free-formable photovoltaic module 100 may correct for a relative position of the flexible photovoltaic elements in the finalized 3D formed solar panel.

For the purpose of clarity and a concise description, features are described herein as part of the same or separate embodiments, however, it will be appreciated that the scope of the invention may include embodiments having combinations of all or some of the features described. For example, while embodiments were shown for vacuum laminating also alternative ways may be envisaged by those skilled in the art having the benefit of the present disclosure for achieving a similar function and result. The various elements of the embodiments as discussed and shown offer certain advantages, such as a flexibility in 3D manufacturing of solar panels. Of course, it is to be appreciated that any one of the above embodiments or processes may be combined with one or more other embodiments or processes to provide even further improvements in finding and matching designs and advantages.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. Method for manufacturing a semi-finished free-formable photovoltaic module for a 3D formed solar panel, the method comprising:
- providing a plurality of flexible photovoltaic elements (10), each flexible photovoltaic element comprising:
o a thin film photovoltaic stack (11) disposed on a flexible carrier (12);
o a first polarity back terminal (14) stretching out along a first portion of a back surface of the flexible photovoltaic element (10);
o a second polarity front terminal (15) including a front current collecting element (16) disposed along a light receiving front surface of the photovoltaic stack, the front current collecting element having side-portions (17) laterally protruding across a side of the photovoltaic stack to form a front contactable second polarity front terminal;
- folding the laterally protruding side-portions of the second polarity front terminal at least in part back along the back surface of the flexible photovoltaic element to form a back contactable second polarity back terminal (18);
- disposing a plurality of flexible electrically conductive wiring elements (30) in a pattern adapted to match a layout of the plurality of flexible photovoltaic elements comprised in the semi-finished free-formable photovoltaic module (100);
- placing the plurality of flexible photovoltaic elements in a layout matching the pattern such that the first and second polarity back terminals have an overlap with the respective conductive wiring elements;
- encapsulating the disposed flexible electrically conductive wiring elements and the placed flexible photovoltaic elements, thereby fixating a relative position of the plurality of laterally separated flexible photovoltaic elements and the plurality of flexible electrically conductive wiring elements and thereby forming an electrically conductive interconnection between adjacent flexible photovoltaic elements.

2. The method according to claim 1, comprising providing an insulator sheet (20) between the back surface of the flexible photovoltaic element and the second polarity back terminal.

3. The method according to claim 1 or 2, comprising providing an electrically conductive sheet (19) to the first and/or second polarity back terminal.

4. The method according to any of the preceding claims, comprising providing cutouts to improve fixation between the wiring element and the flexible photovoltaic element.

5. The method according to any of the preceding claims, wherein the flexible electrically conductive wiring elements are disposed on an encapsulant bottom sheet (41) and wherein the disposed electrically conductive wiring elements are affixed thereto in a heating step prior to placing the plurality of flexible photovoltaic elements.

6. The method according to any of the preceding claims, wherein providing the plurality of flexible photovoltaic elements includes cutting one or more donor flexible photovoltaic elements..

7. A semi-finished free-formable photovoltaic module (100) comprising:
o a plurality of laterally spaced flexible photovoltaic elements (10), each flexible photovoltaic element (10) adapted to provide electric power when illuminated by a light irradiation on a light receiving front side, each (10) comprising:
o a thin film photovoltaic stack (11) disposed on a flexible carrier (12);
o a first polarity back terminal (14) stretching out along a first portion of a back surface of the flexible photovoltaic element (10);
o a second polarity front terminal (15) including a front current collecting element (16) disposed along the light receiving front surface of the photovoltaic stack, the front current collecting element having side-portions (17) laterally protruding across a side of the photovoltaic stack,
wherein the side portions are at least in part folded back along the back surface of the flexible carrier to form a second polarity back terminal (18); and
- a plurality of flexible electrically conductive wiring elements (30) forming an electrically conductive interconnection between adjacent flexible photovoltaic elements, each wiring element having an overlap with the respective back terminals of adjacent flexible photovoltaic elements (10); and
- an encapsulant cover layer (40) covering the plurality of laterally spaced flexible photovoltaic elements (10) and the plurality of flexible electrically conductive wiring elements and wherein the encapsulant cover layer essentially fixates the overlaps of the wiring elements with respect to the respective back terminals.

8. The semi-finished free-formable photovoltaic module (100) according to claim 7, wherein an insulator sheet (20) is provided between the back surface of the flexible photovoltaic element and the second polarity back terminal.

9. The semi-finished free-formable photovoltaic module (100) according to claim 7 or 8, wherein the first and/or second polarity back terminal includes an electrically conductive sheet (19) stretching out along a portion of the back surface to enlarge a contactable area of the respective back terminal.

10. The semi-finished free-formable photovoltaic module (100) according to any of claims 7-9, wherein the electrically conductive wiring elements are provided with cutouts (31) at the overlaps to improve fixation between the wiring element (22) and the flexible photovoltaic elements.

11. A method (300) for manufacturing a 3D formed solar panel
- providing a semi-finished free-formable photovoltaic module (100) according to any of claims 7-10 or obtainable by any of claims 1-6;
- pressure moulding the semi-finished free-formable photovoltaic module to a predefined 3D geometry.

12. A 3D formed solar panel (400) comprising the semi-finished free-formable photovoltaic module according to any of claims 7-10 or a semi-finished free-formable photovoltaic module obtainable by any of claims 1-6.
